# EUROPEAN PATENT SPECIFICATION

(11) **EP 1 757 170 B1**
(45) Date of publication and mention of the grant of the patent: **30.06.2010**
(21) Application number: 05742790.8
(22) Date of filing: 01.06.2005
(51) Int. Cl.: H05B 33/14, H01J 1/72

(54) **ELECTROLUMINESCENT STRUCTURE AND LED WITH AN EL STRUCTURE**
ELEKTROLUMINESZENZSTRUKTUR UND LED MIT EINER EL-STRUKTUR
STRUCTURE ELECTROLUMINESCENTE ET DIODE ELECTROLUMINESCENTE A STRUCTURE ELECTROLUMINESCENTE

(30) Priority: 04.06.2004 EP 04102534
(43) Date of publication of application: 28.02.2007
(73) Proprietor: Philips Intellectual Property & Standards GmbH, 20099 Hamburg (DE); Koninklijke Philips Electronics N.V., 5621 BA Eindhoven (NL)
(72) Inventor: BERTRAM, Dietrich c/o Philips Intellectual Property & Standards GmbH, 52066 Aachen (DE); JUESTEL, Thomas c/o Philips Intellectual Property & Standards GmbH, 52066 Aachen (DE)
(74) Representative: Volmer, Georg
(86) International application number: PCT/IB2005/051778
(87) International publication number: WO 2005/120135

(56) References cited:
- EP-A- 0 972 815
- EP-A- 1 104 799
- WO-A-01/29909
- US-A1- 2002 003 233
- US-A1- 2002 074 558
- US-A1- 2004 062 699
- US-B1- 6 357 889
- US-B1- 6 366 018

## Description

The invention relates to an electroluminescent (EL) structure, particularly a light- emitting diode (LED) with an EL structure. Light from a LED can be partially converted by means of phosphor conversion to generate a mixed color or a white color by conversion of a lower energy color than the pure LED. The phosphor conversion has the drawback that it is not possible to tune the resulting color, because the phosphor has a fixed emission characteristic.

WO97/48138 discloses visible light-emitting devices including UV light-emitting diodes and UV-excitable visible light-emitting phosphors. In these LEDs, an epitaxial buffer-contact layer of n+ GaN is located on a single crystal substrate, on which layer the LED structure including the following epitaxial layers is arranged in sequence: a lower cladding layer of n AlGaN, an active region i GaN, and an upper cladding layer of p AlGaN. A p+ GaN contact layer is provided on top of this LED structure, while a semi-transparent contact layer of, for example, an Au/Ni alloy, and a voltage electrode, with a phosphor layer of a UV-excitable phosphor on the contact layer metallization layers of, for example, Al are provided on the surface buffer/contact layer on either side of the LED structure. A further layer provides grounding via a grounding electrode, while another layer serves as an addressing electrode. WO97/48138 mentions as typical UV-excitable phosphors which may be used for the LED:

| | |
|---|---|
| red: | Y₂O₂S:Eu |
| green: | ZnS:Cu,Ag,Au |
| blue: | BaMgAl₁₀O₁₇:Eu |

The visible light-emitting device of WO 97/48138 as a whole is tunable, because the color that is actually emitted is composed of red, green and blue. However, to achieve this tunability of the device as a whole, three UV light-emitting diodes, each provided with one of three different UV light-excitable phosphors with the characteristics red, blue or green, respectively, have to be handled and controlled.

US 2002/074558 A1 discloses a nitride type compound semiconductor light-emitting element in which a phosphor layer is formed in a multilayer structure constituting the light-emitting element which can emit white light or multi-colored light. The wavelength of the emitted light can be converted into a different wavelength by the light-emitting element alone. The element structure includes a GaN substrate, a re-grown GaN layer thereon and an N type nitride gallium type compound semiconductor layer thereon, an N type nitride gallium type compound semiconductor etch stop layer, an N type nitride gallium type compound semiconductor layer, a nitride gallium type compound semiconductor light-emitting layer, a P type nitride gallium type compound semiconductor layer, a highly-reflective layer of a P type thick-film electrode thereon, and an N type electrode at the back side of the GaN substrate. Three different phosphor layers coated with a transparent conductor film are formed between the GaN substrate and the re-grown GaN layer. The surface of the etch stop layer is exposed through the GaN substrate to form an isolation trench isolating the three phosphor layers coated with a transparent conductor film. One of the phosphor layers is indicative of a phosphor for conversion into red light, one phosphor layer is indicative of a phosphor for conversion into green light and the last phosphor layer is indicative of a phosphor for conversion into blue light. This light-emitting element emits multi-colored light of red, green and blue. Since the phosphor layer is formed in the multilayer that constitutes the light-emitting element, the wavelength of the light can be converted into another wavelength by the light-emitting element alone.

WO 01/29909 A relates to a light-emitting device comprising a plurality of regions of phosphorescent material and a plurality of individually actuable regions of organic light-emitting material capable of emitting radiation of a wavelength that can excite the phosphorescent material to phosphoresce, each region of organic light-emitting material being arranged for emitting radiation to a respective region of a phosphorescent material to cause phosphorescence of the material in that region. A method for forming a light-emitting device is disclosed comprising depositing a plurality of regions of phosphorescent material on a light-transmissive substrate; and forming a plurality of individually actuable regions of organic light-emitting material capable of emitting radiation of a wavelength that can excite the phosphorescent material to phosphoresce, each region of organic light-emitting material being arranged for emitting radiation to a respective region of phosphorescent material to cause for phosphorescence of the material in that region.

US-B1-6 357 889 discloses a color tunable light source including multiple light-emitting components, such as light-emitting diodes or laser diodes with different emission wavelengths and multiple phosphors with different excitation and emission wavelengths. The emission wavelengths of the different light-emitting components are chosen to match the excitations wavelengths of the different phosphors. The light-emitting components are powered by an electrical circuit, which allows separate control of the optical power output of the different wavelength LEDs/LDs. The light from the light-emitting components is arranged to impinge on the combination of phosphors such that the phosphors are excited and emit light at their characteristic wavelengths. By separately adjusting the power to each LED/LD, the amount of light emitted by each phosphor, and hence, through color mixing, the color of the light emitted, is various. The fluorescent material includes two or more different phosphors. A controller has controls for separately controlling the power supplied to each of the three light-emitting components circuits from an external source of power, such as a mains power supply. The phosphors may be combined with the packaging resin used to encapsulate the light-emitting components.

EP 0 972 815 A1 relates to a silicate phosphor with a long afterglow. In a preferred group of long afterglow luminescent material the main chemical formula of the phosphor is: M₂MgSi₂O₇:Eu,Ln or M₃MgSi₂O₈:Eu,Ln wherein M represents Sr₁₋₂ Ca_{z}, 0 ≤ z ≤1.

US 2002/0003233 A1 relates to an LED device that produces white light by performing phosphor conversion. The preferred method for depositing the phosphor thin films is RF-sputtering.

EP 1 104 799 A1 relates to a red emitting luminescent material and discloses the phosphor compounds Ba₂Si₅N₈:Eu, Sr₂Si₅N₈:Eu, Ba₂Si₅N₈:Eu and BaSi₇N₁₀:Eu.

US 2004/0062699 A1 relates to inorganic oxide and phosphor and discloses a phosphor in which a part of Y of a Y₃Al₅O₁₂:Ce phosphor is substituted with either one of Lu, Sc, La, Gd and Sm and/or a part of A1 is substituted with In, B, Tl and Ga, and Si or Si and at least one selected from the group consisting of Ba, Sr, Mg, Ca and Zn are contained, and a light-emitting diode using the same.

It is an object of the invention to provide a color tunable, electroluminescent structure with less losses concerning the brightness, with fewer steps in the manufacturing process and with an overall smaller structure as the prior art electroluminescent structure.

It is another object to provide a method of obtaining white light or a tunable color light by means of mixing the primary colors red, green and blue and by means of phosphor conversion of the ultraviolet or blue light emitted by an emissive layer of the LED.

The object is solved by color tunable, electroluminescent structure on a substrate layer with at least one emissive layer and at least two phosphorescent blends being excitable by the light emitted by the emissive layer, wherein
- a back electrode either is arranged on top of the emissive layer or is connected to a non-insulated layer being adjacent to an emissive layer;
- a surface of the emissive layer comprises two or more separate segments;
- each one of the at least two or more separate segments has a top electrode as front contact to be driven individually; and
- at least one of the two or more separate segments has a different blend of the phosphorescent blends on the surface having the top electrode.

In accordance with the preferred embodiment, the EL structure comprises three separate segments.

This arrangement has a single back electrode, which serves as common back electrode for either of the two or more top electrodes. The common back electrode may either be connected to ground or arranged as a floating electrode. This EL structure may be arranged on a single chip. By separately driving the individual segments or sections, respectively, the corresponding area of the emissive layer becomes active and emits light which, by means of a phosphorescent coverage, may be converted into light of another wavelength. The wavelength depends on the material the phosphorescent coverage consists of. When a current flows from one top electrode to the back electrode, that part of the emissive layer through which the current flows emits light, which is used for the conversion by the phosphorescent coverage on top of this area. Only the active region, which is directly or indirectly sandwiched between the driven top electrode and the common back electrode, emits light.

The phosphorescent blend may consist of a single phosphor or a two-component phosphor blend.

In accordance with one embodiment, the emissive layer emits blue light with a wavelength of ∼ 430 nm to ∼ 485 nm, and the single phosphor or two-component phosphor blend is selected from the group consisting of:
a) (Y₁₋ₓGd₂)₃(Al_{1-y}Ga_{y})₅O₁₂:Ce
b) (Sr₁₋ₓCaₓ)₂SiO₄:Eu
c) (Y₁₋ₓGdₓ)₃(Al_{1-y}Ga_{y})₅O₁₂:Ce + (Sr_{1-x-y}CaₓBa_{y})₂Si₅N₈:Eu
d) (Y₁₋ₓGdₓ)₃(Al_{1-y}Ga_{y})₅O₁₂:Ce + (Sr₁₋ₓCaₓ)S:Eu
e) (Lu₁₋ₓYₓ)₃(Al_{1-y}Ga_{y})₅O₁₂:Ce + (Sr_{1x-y}CaₓBa_{y})₂Si₅N₈:Eu
f) (Lu₁₋ₓYₓ)₃(Al_{1-y}Ga_{y})₅O₁₂:Ce + (Sr₁₋ₓCaₓ)S:Eu
g) (Sr₁₋ₓCaₓ)Si₂N₂O₂:Eu + (Sr_{1-x-y}CaₓBa_{y})₂Si₅N₈:Eu
h) (Sr₁₋ₓCaₓ)Si₂N₂O₂:Eu + (Sr₁₋ₓCaₓ)S:Eu
i) (Ba₁₋ₓSrₓ)SiO₄:Eu + (Sr_{1-x-y}CaₓBa_{y})₂Si₅N₈:Eu
j) (Ba₁₋ₓSrₓ)SiO₄:Eu + (Sr₁₋ₓCax)S:Eu
k) SrGa₂S₄:Eu + (Sr₁₋ₓCaₓ)S:Eu
l) SrGa₂S₄:Eu + (Sr_{1-x-y}CaₓBa_{y})₂Si₅N₈:Eu
wherein x = 0.0 ... 1.0.

In accordance with another embodiment, the electroluminescent structure has an emissive layer that emits ultraviolet light with a wavelength of ∼ 370 nm to ∼ 420 nm, and the single phosphor or two-component phosphor blend is selected from the group consisting of
m) BaMgAl₁₀O₁₇:Eu + (Sr_{1-z}ca_{z})₂SiO₄:Eu
n) BaMgAl₁₀O₁₇:Eu + (Sr_{1-z}Ca_{z})Si₂N₂O₂:Eu + (Sr_{1-z-y}Ca_{z}Bay)₂Si₅N₈:Eu
o) BaMgAl₁₀O₁₇:Eu + (Sr_{1-z}Ca_{z})Si₂N₂O₂:Eu + (Sr_{1-z}Ca_{z})S:Eu
p) BaMgAl₁₀O₁₇:Eu + (Ba_{1-z}Sr_{z})SiO₄:Eu + (Sr_{1-z-y}Ca_{z}Ba_{y})_{z}Si₅N₈:Eu
q) Sr₃MgSi₂O₈Eu + SrGa₂S₄:Eu + (Sr_{1-z-y}Ca_{z}Ba_{y})₂Si₅N₈:Eu
r) Sr₃MgSi₂O₈Eu + (Sr_{1-z}Ca_{z})₂SiO₄:Eu
s) Sr₃MgSi₂O₈Eu + (Sr_{1-z}Ca_{z})Si₂N₂O₂:Eu + (Sr_{1-z-y}Ca_{z}Ba_{y})₂Si₅N₈:Eu
t) Sr₃MgSi₂O₈Eu + (Sr_{1-z}Ca_{z})Si₂N₂O₂:Eu + (Sr_{1-z}Ca_{z})S:Eu
u) Sr₃MgSi₂O₈Eu + (Ba_{1-z}Sr_{z})SiO₄:Eu + (Sr_{1-z-y}Ca_{z}Ba_{y})₂Si₅N₈:Eu
v) Sr₃MgSi₂O₈Eu + SrGa₂S₄:Eu + (Sr_{1-z-y}Ca_{z}Ba_{y})₂Si₅N₈:Eu
wherein z = 0.0 ... 1.0.

The phosphorescent blend may be deposited directly or indirectly on top of the emissive layer by using electrostatic deposition. The structured application of the different phosphors can be realized by biasing every one of the different segments in such a way that the corresponding phosphorescent blend is being deposited or is independent of the bias applied. Further deposition methods may be electrostatic deposition, use of ceramic phosphorous dices, ink-jetting of suspensions, dispensing of mixtures of phosphorous blends and binder or carrier polymers.

The electroluminescent structure may be part of an electroluminescent arrangement, which further comprises one voltage or current source, either for all of the front contacts or for every single front contact, and a controlling unit for individually driving the front contacts. The three components green, red and blue can be mixed by individually driving the front contacts. The mixed light may have different portions of the components red, green and blue and is thus tunable. In order to achieve high color rendering, other or further components such as amber may be selected.

A light-emitting diode with the electroluminescent structure generates a tunable visible light, but is still easy to handle, because only one back electrode has to be contacted.

One advantage of the electroluminescent structure is that it may be arranged on a single chip, which has defined operating conditions.

The electroluminescent structure may be used as a light source or as a lamp and has the advantage of a relatively low heat emission.

With regard to the method of obtaining white light or a tunable color light by means of mixing the primary colors red, green and blue and by means of phosphor conversion of the ultraviolet or blue light emitted by an emissive layer of the LED, the object is achieved by the steps of
- providing an electroluminescent arrangement with a structured surface comprising two or more segments, wherein a different phosphorescent blend is deposited on at least one of the two or more segments, and
- individually driving the front contacts which are arranged on at least one of the two or more segments in order to tune the portions of the components, i.e. the different phosphorescent blends, for the generated visible light.

In order to achieve a high color rendering, further colors such as amber may be selected besides the primary colors red, green and blue.

The invention will be further explained in detail with reference to the accompanying drawings, wherein
Figure 1 is a perspective side view of a schematic EL structure with an ultraviolet light-emitting layer;
Figure 2 is a perspective side view of a schematic EL structure with a blue light-emitting layer;
Figure 3 is a cross-sectional view of a schematic ultraviolet light-emitting LED, and
Figure 4 is a cross-sectional view of a schematic blue light-emitting LED.

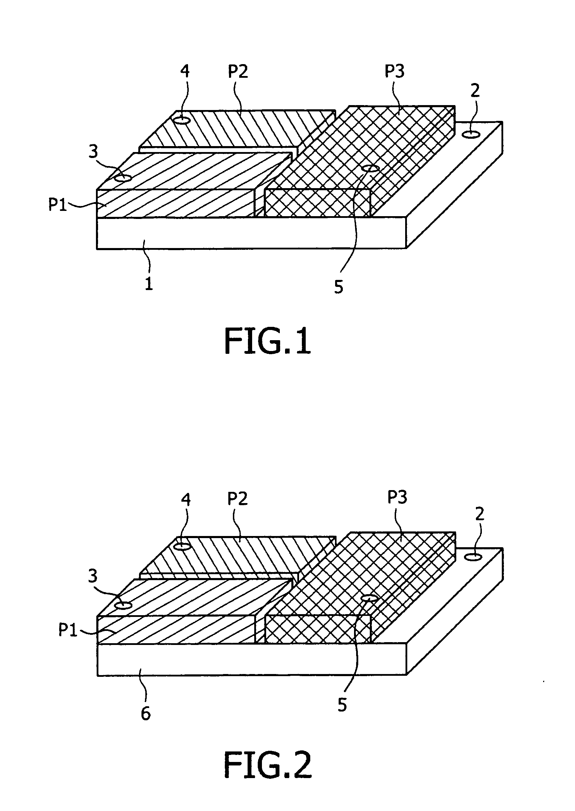

Figure 1 is a perspective side view of a schematic EL structure with an emissive layer 1 emitting ultraviolet light. The emissive layer 1 is provided with a back electrode 2 which, in this illustration, is arranged on top of the emissive layer 1, but may alternatively be arranged underneath the emissive layer as a further layer covering at least the area that is covered by the three segments of phosphorescent blends P1, P2, P3. Each phosphorescent blend P1, P2 and P3 is connected to a corresponding top voltage electrode 3, 4 or 5. When a voltage is applied so that a current flows from at least one of the top electrodes 3, 4 and 5 to the back electrode 2, or vice versa, the area of the emissive layer through which the current flows is activated. This means that the active area emits light, in this example ultraviolet light.

Figure 2 is a perspective side view of a schematic EL structure as described with reference to Figure 1, but with the difference that the emissive layer 6 emits blue light. This means that one of the three segments of the surface of the emissive layer may not be covered with a material that changes the wavelength, but with any transparent material or none at all.

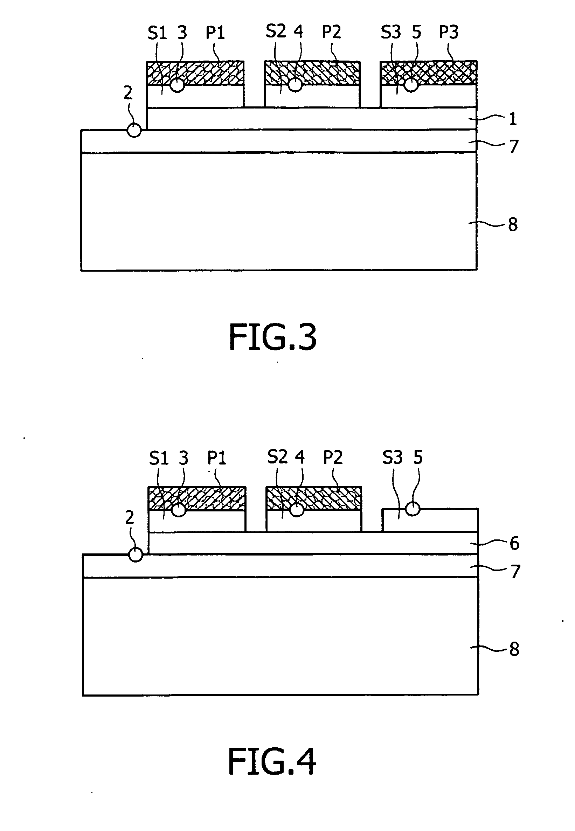

Figure 3 is a cross-sectional view of a schematic LED with a layer 1 emitting ultraviolet light and comprising three segments S1, S2 and S3 on its top surface. As illustrated, the phosphorous blends P1, P2 and P3 are deposited on the top surface of each segment S1, S2 and S3, but may also be deposited on the side walls. In this example, the back electrode 2 is connected to a non-insulated layer 7. Layer 7 preferably reflects light emitted by the emissive layer 1 in order to increase the amount of light rays, which reach and pass the phosphorescent blends. The substrate 8 on which the EL structure is arranged may be an InGaN-substrate.

Figure 4 is a cross-sectional view of a schematic LED as described with reference to Figure 3, but with the difference that the emissive layer 6 emits blue light. This means that one of the three segments of the surface of the emissive layer is not covered with a material that changes the wavelength, but with any transparent material.

In summary, the invention relates to an EL structure with a single ultraviolet or blue light-emitting layer that is connected to a back electrode. The top surface comprises three separate segments for the primary colors red, green and blue. Another single phosphorescent blend or a two-component phosphorescent blend is deposited on at least two of the three segments. Each of the three segments can be individually driven by a corresponding top electrode. Thus, a single chip solution is provided for a LED with tunable visible light.

## Claims

1. A color tunable, electroluminescent structure on a substrate layer (8) with at least one emissive layer (1,6) and at least two phosphorescent blends (P1, P2, P3) being excitable by the light emitted by the emissive layer, **characterized in that**
- a back electrode (2) either is arranged on top of the emissive layer (1, 6) or is connected to a non-insulated layer (7) being adjacent to the emissive layer (1, 6);
- a surface of the emissive layer comprises two or more separate segments (S1, S2, S3);
- each one of the at least two or more separate segments (S 1, S2, S3) has a top electrode (3,4,5) as front contact to be driven individually;
- at least two or more phosphorescent blends (P1, P2, P3) are deposited on the top surface of each segment (S1, S2, S3); and
- at least one separate segment (S1) of the two or more separate segments (S1, S2, S3) has the phosphorescent blend (P1) different to the phosphorescent blends ( P2, P3) on the surface having the top electrode.

2. The electroluminescent structure of claim 1, **characterized in that** the phosphorescent blend (P1, P2, P3) consists of a single phosphor or a two-component phosphor blend.

3. The electroluminescent structure of claim 2, with an emissive layer (6) that emits blue light (∼430 nm to ∼485 nm), **characterized in that** the single phosphor or two-component phosphor blend is selected from the group consisting of
a) (Y₁₋ₓGdₓ)₃(Al_{1-y}Ga_{y})₅O₁₂:Ce
b) (Sr₁₋ₓCaₓ)₂SiO₄:Eu
c) (Y₁₋ₓGdₓ)₃(Al_{l-y}Ga_{y})₅O₁₂:Ce + (Sr_{1-x-y}CaₓBa_{y})₂Si₅N₈:Eu
d) (Y₁₋ₓGdₓ)₃(Al_{1-y}Ga_{y})₅O₁₂:Ce + (Sr₁₋ₓCaₓ)S:Eu
e) (Lu₁₋ₓYₓ)₃(Al_{1-y}Ga_{y})₅O₁₂:Ce + (Sr_{1-x-y}CaₓBa_{y})₂Si₅N₈:Eu
f) (Lu₁₋ₓ)₃(Al_{1-y}Ga_{y})₅O₁₂:Ce + (Sr₁₋ₓCaₓ)S:Eu
g) (Sr₁₋ₓCaₓ)Si₂N₂O₂:Eu + (Sr_{1-x-y}CaₓBa_{y})₂Si₅N₈:Eu
h) (Sr₁₋ₓCaₓ)Si₂N₂O₂:Eu + (Sr₁₋ₓCaₓ)S:Eu
i) (Ba₁₋ₓSrₓ)SiO₄:Eu + (Sr_{1-x-y}CaₓBa_{y})₂Si₅N₈:Eu
j) (Ba₁₋ₓSrₓ)SiO₄:Eu + (Sr₁₋ₓCaₓ)S:Eu
k) SrGa₂S₄:Eu + (Sr₁₋ₓCaₓ)S:Eu
l) SrGa₂S₄:Eu + (Sr_{1-y}CaₓBa_{y})₂Si₅N₈:Eu
whereby x = 0,0 ... 1,0.

4. The electroluminescent structure of claim 2, with an emissive layer (1) that emits ultraviolet light (∼370 nm - ∼420 nm), **characterized in that** the single phosphor or two-component phosphor blend is selected from the group consisting of
m) BaMgAl₁₀O₁₇:Eu + (Sr_{1-z}Ca_{z})₂SiO₄:Eu
n) BaMgAl₁₀O₁₇:Eu + (Sr_{1-z}Ca_{z})Si₂N₂O₂:Eu + (Sr_{1-z-y}Ca_{z}Ba_{y})₂Si₅Ni₈:Eu
o) BaMgAl₁₀O₁₇:Eu + (Sr_{1-z}Ca_{z})Si₂N₂O₂:Eu + (Sr_{1-z}Ca_{z})S:Eu
p) BaMgAl₁₀O₁₇:Eu + (Ba_{1-z}Sr_{z})SiO₄:Eu + (Sr_{1-z-y}Ca_{z}Ba_{y})₂Si₅N₈:Eu
q) Sr₃MgSi₂O₈Eu + SrGa₂S₄:Eu + (Sr_{1-z-y}Ca_{z}Ba_{y})₂Si₅N₈:Eu
r) Sr₃MgSi₂O₈Eu + (Sr_{1-z}Ca_{z})₂SiO₄:Eu
s) Sr₃MgSi₂O₈Eu + (Sr_{1-z}Ca_{z})Si₂N₂O₂:Eu + (Sr_{1-z-y}Ca_{z}Ba_{y})₂Si₅N₈:Eu
t) Sr₃MgSi₂O₈Eu + (Sr_{1-z}Ca_{z})Si₂N₂O₂:Eu + (Sr_{1-z}Ca_{z})S:Eu
u) Sr₃MgSi₂O₈Eu + (Ba_{1-z}Sr_{z})SiO₄:Eu + (Sr_{1-z-y}Ca_{z}Ba_{y})₂Si₅N₈:Eu
v) Sr₃MgSi₂O₈Eu + SrGa₂S₄:Eu + (Sr_{1-z-y}Ca_{z}B_{y})₂Si₅N₈:Eu
whereby z = 0,0 ... 1,0.

5. An electroluminescent structure as claimed in anyone of the preceding claims, **characterized in that** the phosphorescent blends (P1, P2, P3) are deposited by using electrostatic deposition, ceramic phosphorous dices, ink-jetting of suspensions, dispensing of mixtures of phosphorous blends and binder or carrier polymers.

6. An electroluminescent arrangement comprising an electroluminescent structure as claimed in any one of the preceding claims, one voltage /current source, either for all of the front contacts (3, 4, 5) or for every single front contact, and a controlling unit for individually driving the front contacts.

7. A light-emitting diode with an electroluminescent structure as claimed in any one of claims 1 to 5.

8. An electroluminescent structure as claimed in one of the claims 1 to 5, **characterized in that** it is arranged on a single chip.

9. Use of an electroluminescent structure as claimed in any one of claims 1 to 5, as a light source or as a lamp.

10. A method of obtaining white light from a light-emitting diode by means of mixing at least the primary colors red, green and blue and by means of phosphor conversion of the ultraviolet or blue light emitted by an emissive layer (1,6) of the LED, **characterized by** the steps of - providing the emissive layer (1,6) with a structured surface comprising two or more segments (S1, S2, S3) with at least two or more phosphorescent blends (P1, P2, P3) deposited on the top surface of each segment (S1, S2, S3), wherein the phosphorescent blend (P1) different to the phosphorescent blends (P2, P3) is deposited on at least one separate segment (S1) of the two or more segments (S1, S2, S3), and - individually driving the front contacts which are arranged on at least one of the two or more segments in order to tune the portions of the components for the generated visible light.

## Patentansprüche

1. Auf Farbe abstimmbare Elektrolumineszenzstruktur auf einer Substratschicht (8) mit wenigstens einer Emissionsschicht (1,6) und wenigstens zwei phosphoreszierenden Mischungen (P1, P2, P3), die mit Hilfe des von der Emissionsschicht ausgestrahlten Lichtes anregbar sind, **dadurch gekennzeichnet, dass**
- eine Back-Elektrode (2) entweder auf der Emissionsschicht (1,6) vorgesehen oder mit einer nicht isolierenden, an die Emissionsschicht (1,6) grenzenden Schicht (7) verbunden ist;
- eine Fläche der Emissionsschicht zwei oder mehr einzelne Segmente (S1, S2, S3) aufweist;
- jedes der wenigstens zwei oder mehr einzelnen Segmente (S1, S2, S3) eine Top-Elektrode (3, 4, 5) als einzeln anzusteuernden Frontkontakt aufweist;
- wenigstens zwei oder mehr phosphoreszierende Mischungen (P1, P2, P3) auf der oberen Fläche jedes Segmentes (S1, S2, S3) vorgesehen sind; und
- wenigstens ein einzelnes Segment (S1) der zwei oder mehr einzelnen Segmente (S1, S2, S3)die von den phosphoreszierenden Mischungen (P2, P3) abweichende phosphoreszierende Mischung (P1) auf der Fläche mit der Top-Elektrode aufweist.

2. Elektrolumineszenzstruktur nach Anspruch 1, **dadurch gekennzeichnet, dass** die phosphoreszierende Mischung (P1, P2, P3) aus einer einzigen Phosphormischung oder aus einer Zweikomponenten-Phosphormischung besteht.

3. Elektrolumineszenzstruktur nach Anspruch 2, mit einer Emissionsschicht (6), die blaues Licht (∼430 nm bis ∼485 nm) ausstrahlt, **dadurch gekennzeichnet, dass** die einzelne Phosphormischung oder die Zweikomponenten-Phosphormischen selektiert wird aus der Gruppe, die besteht aus:
a) (Y₁₋ₓGdₓ)₃(Al_{1-y}Ga_{y})₅O₁₂: Ce
b) (Sr₁₋ₓCaₓ)₂(SiO₄: Eu
c) (Y₁₋ₓGdₓ)₃(Al_{1-y}Ga_{y})₅O₁₂: Ce + (Sr_{1-x-y}CaₓBa_{y})₂Si₅N₈: Eu
d) (Y₁₋ₓGdₓ)₃(Al_{1-y}Ga_{y})₅O₁₂: Ce + (Sr₁₋ₓCaₓ)S: Eu
e) (Lu₁₋ₓYₓ)₃(Al_{1-y}Ga_{y})₅O₁₂: Ce + (Sr_{1-x-y}CaₓBa_{y})₂Si₅N₈: Eu
f) (Lu₁₋ₓYₓ)₃(Al_{1-y}Ga_{y})₅O₁₂: Ce + (Sr₁₋ₓCaₓ)S: Eu
g) (Sr₁₋ₓCaₓ)Si₂N₂O₂:Eu + SrGa₂S₄: Eu
h) (Sr₁₋ₓCaₓ)Si₂N₂O₂:Eu + (Sr₁₋ₓCaₓ)S: Eu
i) (Ba₁₋ₓSrₓ)SiO₄:Eu + (Sr_{1-x-y}CaₓBa_{y})₂Si₅N₈: Eu
j) (Ba₁₋ₓSrₓ)SiO₄:Eu + (Sr₁₋ₓCaₓ)S: Eu
k) SrGa₂S₄: Eu + (Sr₁₋ₓCaₓ)S: Eu
l) SrGa₂S₄: Eu + (Sr_{1-x-y}CaₓBa_{y})₂Si₅N₈: Eu
wobei x = 0,0 ... 1,0 ist.

4. Elektrolumineszenzstruktur nach Anspruch 2 mit einer Emissionsschicht (1), die UV-Licht (∼370 nm - ∼420 nm) ausstrahlt, **dadurch gekennzeichnet, dass** die einzelne Phosphormischung oder die Zweikomponenten-Phosphormischung aus der nachfolgenden Gruppe selektiert wird:
m) BaMgAl₁₀O₁₇: Eu + (Sr_{1-z}Ca_{z})₂SiO₄: Eu
n) BaMgAl₁₀O₁₇: Eu + (Sr_{1-z}Ca_{z})Si₂N₂O₂: Eu + (Sr_{1-z-y}Ca_{z}Ba_{y})₂Si₅N₈: Eu
o) BaMgAl₁₀O₁₇: Eu + (Sr_{1-z}Ca_{z})Si_{z}N₂O₂: Eu + (Sr_{1-z}Ca_{z})S: Eu
p) BaMgAl₁₀O₁₇: Eu + (Ba_{1-z}Sr_{z})SiO₄: Eu + (Sr_{1-z-y}Ca_{z}Ba_{y})₂Si₅N₈: Eu
q) Sr₃MgSi₂O₈Eu + SrGa₂S₄: Eu + (Sr_{1-z-y}Ca_{z}Ba_{y})₂Si₅N₈: Eu
r) Sr₃MgSi₂O₈Eu + (Sr_{1-z}Ca_{z})₂SiO₄: Eu
s) Sr₃MgSi₂O₈Eu + (Sr_{1-z}Ca_{z})Si₂N₂O₂: Eu + (Sr_{1-z-y}Ca_{z}Ba_{y})₂Si₅N₈: Eu
t) Sr₃MgSi₂O₈Eu + (Sr_{1-z}Ca_{z})Si₂N₂O₂: Eu + (Sr_{1-z}Ca_{z})S: Eu
u) Sr₃MgSi₂O₈Eu + (Ba_{1-z}Sr_{z})SiO₄: Eu + (Sr_{1-z-y}Ca_{z}Ba_{y})₂Si₅N₈: Eu
v) Sr₃MgSi₂O₈Eu + SrGa₂S₄: Eu + (Sr_{1-z-y}Ca_{z}Ba_{y})₂Si₅N₈: Eu
wobei z = 0,0 ... 1,0 ist.

5. Elektrolumineszenzstruktur nach einem der vorstehenden Ansprüche, **dadurch gekennzeichnet, dass** die phosphoreszierenden Mischungen (P1, P2, P3) im elektrostatisch Ablagerungsverfahren, durch Verwendung keramischer Phosphorwürfel, durch Farbspritzung von Suspensionen, durch Verteilung von Gemischen von Phosphormischungen und Bindemitteln oder Trägerpolymeren.

6. Elektrolumineszenzvorrichtung mit einer Elektrolumineszenzstruktur nach einem der vorstehenden Ansprüche, mit einer Spannungs-/Stromquelle, entweder für alle Frontkontakte (3, 4, 5) oder für jeden einzelnen Frontkontakt, und mit einer Steuereinheit zur einzelnen Ansteuerung der Frontkontakte.

7. Leuchtdiode mit einer Elektrolumineszenzstruktur nach einem der Ansprüche 1 bis 5.

8. Elektrolumineszenzstruktur nach einem der Ansprüche 1 bis 5, **dadurch gekennzeichnet, dass** diese auf einem einzigen Chip angeordnet ist.

9. Verwendung einer Elektrolumineszenzstruktur nach einem der Ansprüche 1 bis 5, als Lichtquelle oder als Lampe.

10. Verfahren zum Erhalten von weißem Licht von einer Leuchtdiode durch Mischung wenigstens der Primärfarben Rot, Grün und Blau und durch Phosphorumwandlung des ultravioletten oder blauen Lichtes, das von einer Emissionsschicht (1,6) der Leuchtdiode ausgestrahlt wird, **gekennzeichnet durch** die nachfolgenden Verfahrensschritte:
- das Versehen der Emissionsschicht (1,6) mit einer strukturierten Oberfläche mit zwei oder mehr Segmenten (S1, S2, S3) mit wenigstens zwei oder mehr Phosphoreszenzmischungen (P1, P2, P3), vorgesehen auf der oberen Fläche jedes Segmentes (S1, S2, S3), wobei die Phosphoreszenzmischung (P1), die von den Phosphoreszenzmischungen (P2, P3) abweicht, auf wenigstens einem separaten Segment (S1) der zwei oder mehr Segmente (S1, S2, S3) angebracht wird, und
- das einzelne Ansteuern der Frontkontakte, die auf wenigstens einem der zwei oder mehr Segmente vorgesehen sind, damit die Teile der Komponenten für das erzeugte sichtbare Licht abgestimmt werden.

## Revendications

1. Structure électroluminescente à couleur réglable sur une couche substrat (8) comprenant au moins une couche émissive (1, 6) et au moins deux mélanges homogènes phosphorescents (P1, P2, P3) pouvant être excités par la lumière émise par la couche émissive, **caractérisée en ce que**
- une électrode arrière (2) est soit disposée sur la partie supérieure de la couche émissive (1,6) soit raccordée à une couche non isolée (7) adjacente à la couche émissive (1,6);
- une surface de la couche émissive comprend deux segments séparés ou plus (S1, S2, S3) ;
- chacun des deux segments séparés (S1, S2, S3) ou plus présente une électrode supérieure (3, 4, 5) comme contact avant devant être entraîné individuellement ;
- au moins deux mélanges homogènes phosphorescents (P1, P2, P3) ou plus sont déposés sur la surface supérieure de chaque segment (S1, S2, S3) ; et
- le mélange homogène phosphorescent (P1) au moins un segment séparé (S1) des deux segments séparés (S1, S2, S3) ou plus est différent des mélanges homogènes phosphorescents (P2, P3) sur la surface présentant l'électrode supérieure.

2. Structure électroluminescente selon la revendication 1, **caractérisée en ce que** le mélange homogène phosphorescent (P1, P2, P3) est constitué d'un mélange homogène monophosphoreux ou à deux composants phosphoreux.

3. Structure électroluminescente selon la revendication 2, comprenant une couche émissive (6) émettant une lumière bleue (∼ 430 nm à ∼ 485 nm), **caractérisée en ce que** le mélange homogène monophosphoreux ou à deux composants phosphoreux est sélectionné parmi le groupe constitué par
a) (Y₁₋ₓGdₓ)₃(Al_{1-y}Ga_{y})₅O₁₂:CE
b) (Sr₁₋ₓCaₓ)₂SiO₄:Eu
c) (Y₁₋ₓGdₓ)₃(Al_{1-y}Ga_{y})₅O₁₂:Ce + (Sr_{1-x-y}CaₓBa_{y})₂Si₅N₈:Eu
d) (Y₁₋ₓGdₓ)₃(Al_{1-y}Ga_{y})₅O₁₂:Ce + (Sr₁₋ₓCaₓ)S:Eu
e) (Lu₁₋ₓYₓ)₃(Al_{1-y}Ga_{y})₅O₁₂:Ce + (Sr_{1-x-y}CaₓBa_{y})₂Si₅N₈:Eu
f) (Lu₁₋ₓYₓ)₃(Al_{1-y}Ga_{y})₅O₁₂:Ce + (Sr₁₋ₓCaₓ)S:Eu
g) (Sr₁₋ₓCaₓ)Si₂N₂O₂:Eu + (Sr_{1-x-y}CaₓBa_{y})₂Si₅N₈:Eu
h) (Sr₁₋ₓCaₓ)Si₂N₂O₂:Eu + (Sr₁₋ₓCaₓ)S:Eu
i) (Ba₁₋ₓSrₓ)SiO₄:Eu + (Sr_{1-x-y}CaₓBa_{y})₂Si₅N₈:Eu
j) (Ba₁₋ₓSrₓ)SiO₄:Eu + (Sr₁₋ₓCaₓ)S:Eu
k) SrGa₂S₄:Eu + (Sr₁₋ₓCaₓ)S:Eu
l) SrGa₂S₄:Eu +(Sr_{1-x-y}CaₓBa_{y})₂Si₅N₈:Eu
sachant que x = 0,0 ... 1,0

4. Structure électroluminescente selon la revendication 2, comprenant une couche émissive (1) émettant une lumière ultraviolette (∼ 370 nm à ∼ 420 nm), **caractérisée en ce que** le mélange homogène monophosphoreux ou à deux composants phosphoreux est sélectionné parmi le groupe constitué par
m) BaMgAl₁₀O₁₇:Eu + (Sr_{1-z}Ca_{z})₂SiO₄:Eu
n) BaMgAl₁₀O₁₇:Eu + (Sr_{1-z}Ca_{z})Si₂N₂O₂:Eu + (Sr_{1-z-y}Ca_{z}Ba_{y})₂Si₅N₈:Eu
o) BaMgAl₁₀O₁₇:Eu + (Sr_{1-z}Ca_{z})Si₂N₂O₂:Eu + (Sr_{1-z}Ca_{z})S:Eu
p) BaMgAl₁₀O₁₇:Eu + (Ba_{1-z}Sr_{z})SiO₄:Eu + (Sr_{1-z-y}Ca_{z}Bay)₂Si₅N₈:Eu
q) Sr₃MgSi₂O₈Eu + SrGa₂S₄:Eu + (Sr_{1-z-y}Ca_{z}Ba_{y})₂Si₅N₈:Eu
r) Sr₃MgSi₂O₈Eu + (Sr_{1-z}Ca_{z})₂SiO₄:Eu
s) Sr₃MgSi₂O₈Eu + (Sr_{1-z}Ca_{z})Si₂N₂O₂:Eu + (Sr_{1-z-y}Ca_{z}Ba_{y})₂Si₅N₈:Eu
t) Sr₃MgSi₂O₈Eu + (Sr_{1-z}Ca_{z})Si₂N₂O₂:Eu + (Sr_{1-z}Ca_{z})S:Eu
u) Sr₃MgSi₂O₈Eu + (Ba_{1-z}Sr_{z})SiO₄:Eu + (Sr_{1-z-y}Ca_{z}Ba_{y})₂SisN₈:Eu
v) Sr₃MgSi₂O₈Eu + SrGa₂S₄:Eu + (Sr_{1-z-y}Ca_{z}Ba_{y})₂Si₅N₈:Eu
sachant que z = 0,0 ... 1,0.

5. Structure électroluminescente selon l'une quelconque des revendications précédentes, **caractérisée en ce que** les mélanges homogènes phosphorescents (P1, P2, P3) sont déposés au moyen d'un dépôt électrostatique, de dés phosphoreux céramiques, d'un jet d'encre de suspensions, d'une distribution de mélanges de mélanges phosphoreux et d'un liant ou de polymères de support.

6. Agencement électroluminescent comprenant une structure électroluminescente selon l'une quelconque des revendications précédentes, une source de tension/courant, soit pour tous les contacts avant (3, 4, 5) soit pour chaque contact avant, et une unité de commande destinée à entraîner individuellement les contacts avant.

7. Diode électroluminescente comprenant une structure électroluminescente selon l'une quelconque des revendications 1 à 5.

8. Structure électroluminescente selon l'une quelconque des revendications 1 à 5, **caractérisée en ce qu'**elle est disposée sur une seule puce.

9. Utilisation d'une structure électroluminescente selon l'une quelconque des revendications 1 à 5, en tant que source de lumière ou lampe.

10. Procédé d'obtention d'une lumière blanche à partir d'une diode électroluminescente en mélangeant au moins les couleurs primaires rouge, vert et bleu et au moyen d'une conversion phosphoreuse de la lumière ultraviolette ou bleue émise par une couche émissive (1, 6) de la DEL, **caractérisé par** les étapes consistant à
- doter la couche émissive (1, 6) d'une surface structurée comprenant deux segments (S1, S2, S3) ou plus dotés d'au moins deux mélanges homogènes phosphorescents (P1, P2, P3) ou plus déposés sur la surface supérieure de chaque segment (S1, S2, S3), le mélange homogène phosphorescent (P1) différent des mélanges homogènes phosphorescents (P2, P3) étant déposé sur au moins un segment séparé (S1) des deux segments (S1, S2, S3) ou plus, et
- entraîner individuellement les contacts avant disposés sur au moins un des deux segments ou plus afin de régler les parties des composants pour la lumière visible générée.
